# EUROPEAN PATENT SPECIFICATION

(11) **EP 3 506 102 B1**
(45) Date of publication and mention of the grant of the patent: **03.02.2021**
(21) Application number: 17210577.7
(22) Date of filing: 26.12.2017
(51) Int. Cl.: G06F 11/32, H03M 7/30, G06F 11/30

(54) **A METHOD FOR CONTROLLING ACTIVITY INDICATORS OF AN ELECTRONIC APPLIANCE**
VERFAHREN ZUR STEUERUNG VON AKTIVITÄTSINDIKATOREN EINES ELEKTRONISCHEN GERÄTS
PROCÉDÉ DE COMMANDE DES INDICATEURS D'ACTIVITÉ D'UN APPAREIL ÉLECTRONIQUE

(43) Date of publication of application: 03.07.2019
(73) Proprietor: Advanced Digital Broadcast S.A., 1293 Bellevue (CH)
(72) Inventor: Mazur, Aleksander, 65-119 Zielona Gora (PL)
(74) Representative: Kancelaria Eupatent.pl Sp. z.o.o

(56) References cited:
- CN-A- 103 167 682
- US-A- 5 652 913
- US-A1- 2003 005 306
- US-A1- 2004 078 682

## Description

### TECHNICAL FIELD

The present disclosure relates to a method for controlling activity indicators of an electronic appliance.

### BACKGROUND

Electronic appliances are equipped with activity indicators, typically visual indicators in form of diodes (e.g. LEDs), which are used to show up/down status of various interfaces of the appliance, e.g. DSL, Wi-Fi, LAN, USB. When the status of the particular interface is "up", the corresponding indicator can for example blink whenever a data transfer is being performed at the moment. This is usually implemented by modifying drivers of each type of the interface to make them provide active notifications of switching between "active" and "idle" state. Then such notifications (carrying information about activity/being idle) are routed to the appropriate indicators and trigger blinking.

The solution based on triggering activity status directly from drivers of particular interfaces usually requires modifying a source code of each driver, e.g. injecting calls to an API at proper places of the original code, without changing its behaviour and with respect to timing constraints. In case of binary drivers this is impossible and in other cases doing such change may be forbidden by the license, not advisable due to e.g. voiding warranty, or simply impractical due to the amount of workload. Delivering modified interface drivers increases maintenance cost significantly.

A prior art of CN103167682A discloses an indication device of a running status, the indication device comprising a control unit, a coding/modulating unit, a logic AND unit, a driver and an indication lamp. The solution does not require additional hardware in order to report multiple running statuses of the tested device.

Another publication US2003005306A1 describes a method and apparatus for data synchronization between a client and a repository. According to one embodiment, data synchronization between a client and a repository is performed based on the results of a comparison between message digests associated with files stored on the client and a database of message digests stored on the repository. The message digests generated on the client uniquely identify the content of files stored on the client. This unique identification of the contents of the files on the client is accomplished by performing a cryptographic hash of the contents of the individual files. The database of message digests stored on the repository contains message digests from clients that are stored in the database at the time of data synchronization. By comparing message digests generated on the client with those on the repository, the need for data synchronization may be efficiently determined.

Further, US2004078682A1 discloses monitoring normal computer hardware status in operation and notifying of abnormal computer hardware modes to alert system manager comprising: First acquiring a virtual memory storage location by a pertained computer system when its operating system boots up, reserving the allocated virtual memory storage, switching to protect mode, and booting BIOS driver in the operating system. Second, the operating system based software program registers a callback function defined by a set of system defined OEM functions to check the existence of the software program, retrieve the address of hardware status and hardware mapping status, acknowledge and process the change of hardware status, and return back to the operating system. Third, the operating system displays the hardware status information controlled by the operating system based software program to report to system managers or users.

Lastly, US5652913A presents a method and system for providing intercommunication of I/O access factors between a file system and device driver, described as follows. A factor data block is provided which stores I/O access factors used by a file system and a device driver. The file system performs application program requests to access files by providing appropriate file system requests to the device driver based on the I/O access factors. The device driver performs the file system requests by controlling access to an appropriate peripheral device based on the I/O access factors. In a preferred embodiment, the I/O access factors include real time status data indicating a current status of I/O processing. The I/O access factors also include device constraint data indicating limitations of the peripheral devices. During an I/O access, the file system reads the real time status data and device constraint data and performs an application program request based on the real time status data and device constraint data, passing a file system request to the device driver. The device driver reads the real time status data and performs the file system request based on the real time status data.

Therefore, there is a need to provide a method for controlling activity indicators of electronic appliances connected to computer networks or equipped with USB host-type ports, in which the appropriate indicators are operated basing on statistics provided by interface drivers.

### SUMMARY

There is disclosed a system and method for controlling activity indicators for indicating activity of interface drivers of an electronic appliance as defined in the appended claims.

There is also disclosed a computer program comprising program code means for performing all the steps of the computer-implemented method as described above when said program is run on a computer, as well as a computer readable medium storing computer-executable instructions performing all the steps of the computer-implemented method as described above when executed on a computer.

### BRIEF DESCRIPTION OF DRAWINGS

The method presented herein is presented by means of example embodiments on a drawing, wherein:
Fig. 1 presents a simplified structure of a typical SoC-based (System on Chip) router;
Fig. 2A presents controlling activity indicators in a typical prior art appliance;
Fig. 2B presents controlling the activity indicators according to the method of the present invention in an electronic appliance;
Fig. 2C presents CPU modules;
Fig. 3A presents data stored in a memory;
Fig. 3B presents an example of memory contents;
Figs. 4A-4B present a flowchart of the method for controlling the activity indicators;
Fig. 5 presents an example of file system directories for network interfaces with matching sample system-level names.

### NOTATION AND NOMENCLATURE

Some portions of the detailed description which follows are presented in terms of data processing procedures, steps or other symbolic representations of operations on data bits that can be performed on computer memory. Therefore, a computer executes such logical steps thus requiring physical manipulations of physical quantities.

Usually these quantities take the form of electrical or magnetic signals capable of being stored, transferred, combined, compared, and otherwise manipulated in a computer system. For reasons of common usage, these signals are referred to as bits, packets, messages, values, elements, symbols, characters, terms, numbers, or the like.

Additionally, all of these and similar terms are to be associated with the appropriate physical quantities and are merely convenient labels applied to these quantities. Terms such as "processing" or "creating" or "transferring" or "executing" or "determining" or "detecting" or "obtaining" or "selecting" or "calculating" or "generating" or the like, refer to the action and processes of a computer system that manipulates and transforms data represented as physical (electronic) quantities within the computer's registers and memories into other data similarly represented as physical quantities within the memories or registers or other such information storage.

A computer-readable (storage) medium, such as referred to herein, typically may be non-transitory and/or comprise a non-transitory device. In this context, a non-transitory storage medium may include a device that may be tangible, meaning that the device has a concrete physical form, although the device may change its physical state. Thus, for example, non-transitory refers to a device remaining tangible despite a change in state.

### DETAILED DESCRIPTION

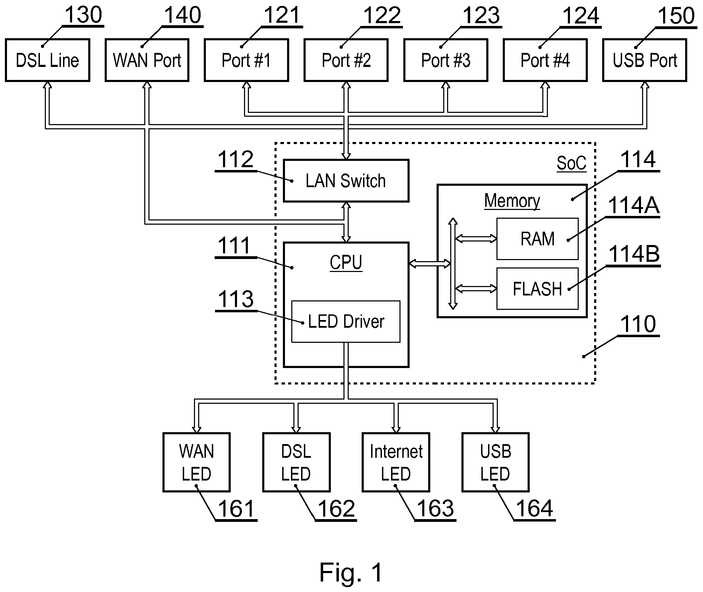

Fig. 1 presents a simplified structure of an example of an electronic appliance (in particular, a networking appliance) - a typical SoC-based (System on Chip) router. The router is equipped with a system on chip 110 module, which comprises a CPU 111 with a LED driver 113, a LAN switch 112, a memory unit 114 including RAM 114A and Flash 114B blocks. The router also comprises other external interfaces: a DSL line connector 130, a WAN Ethernet port 140, LAN Ethernet ports 121-124, a USB port 150 and LED indicators 161-164.

The example presented herein comprises LED indicators 161-164, but any other types of indicators can be used (including other visual indicators, or audio indicators), being controlled individually or by a common indicator driver 113.

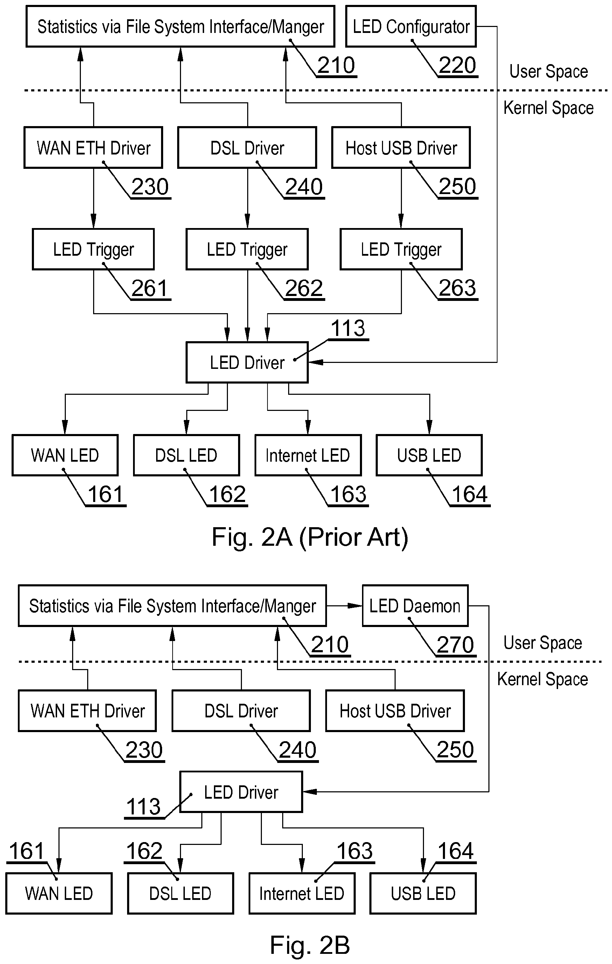

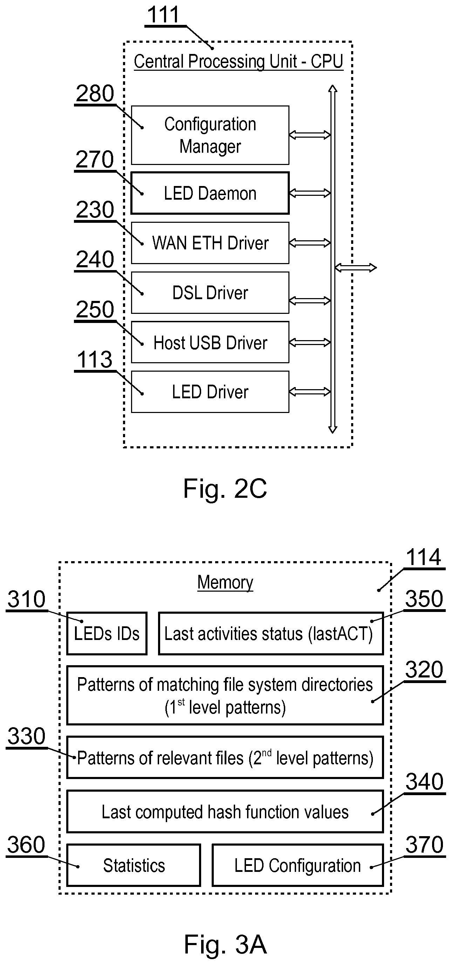

Fig. 2A presents details of controlling activity indicators in a typical prior art appliance. The electronic appliance utilizes several interface drivers (in particular, external interfaces, and more particularly, networking interfaces), such as: a WAN Ethernet driver 230, a DSL driver 240, a host USB driver 250. Each driver 230, 240, 250 which performs operations considered as activity to be indicated by visual indicators 161, 162, 163, 164 (e.g. LEDs) makes calls to a corresponding LED trigger 261, 262, 263. Whenever an operation of interest is performed (e.g. a single network packet is transmitted or received, or a single USB request block is transferred), the driver makes a call to one of the corresponding LED triggers 261, 262, 263, which changes its state to ACTIVE and launches a timer. In case when another call occurs before the timer fires, the ACTIVE state is kept, and the timer is prolonged. In case the timer triggers before next call, the LED trigger changes the state back to INACTIVE. The timeout is tuned to a value greater than a period of incoming calls during normal continuous operation, so that for example during transfer of a larger block of data via a USB the USB host driver 250 periodically calls the LED trigger 263, with a frequency such that the timer doesn't fire and the LED trigger 263 keeps the ACTIVE state until the transfer is finished. The LED triggers 261, 262, 263 pass the activity state transition messages (from INACTIVE to ACTIVE and vice-versa) for each LED indicator 161-164, to a LED driver 113. The LED driver 113 maps each activity state received from the LED triggers 261, 262, 263 to the particular LED indicator 161-164, because whenever a mapping changes, a configuration manager 280 (depicted in Fig. 2C) invokes a helper program LED configurator 220 which passes that mapping to the LED driver 113. Simultaneously, all involved drivers 230, 240, 250 perform operations necessary to make their statistics via a file system interface/manager 210. The statistics are available to the rest of the system (e.g. number of received/transmitted packets/bytes, and many more), but these data are not used by the above method for indicating activity status.

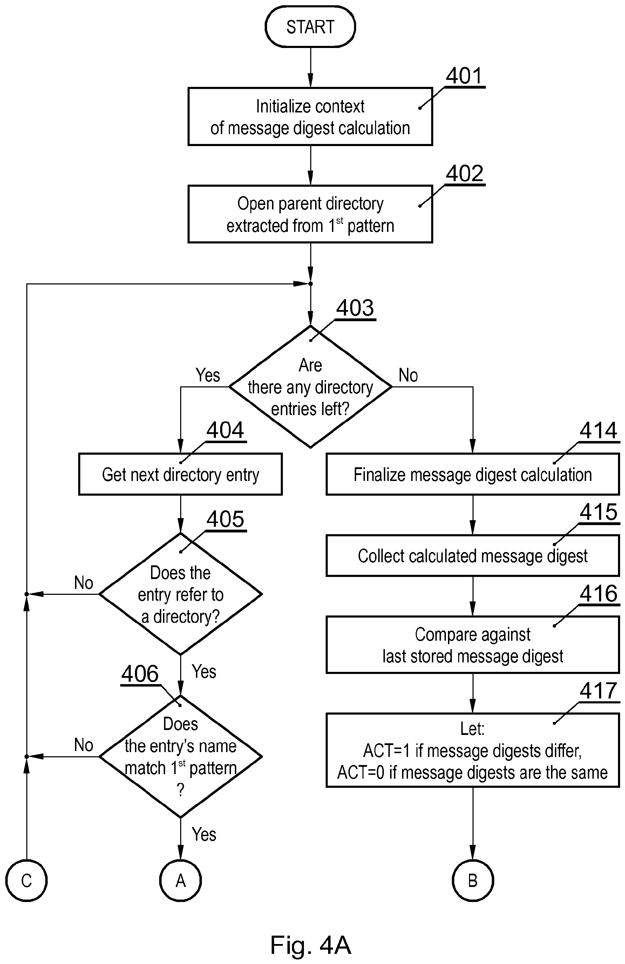

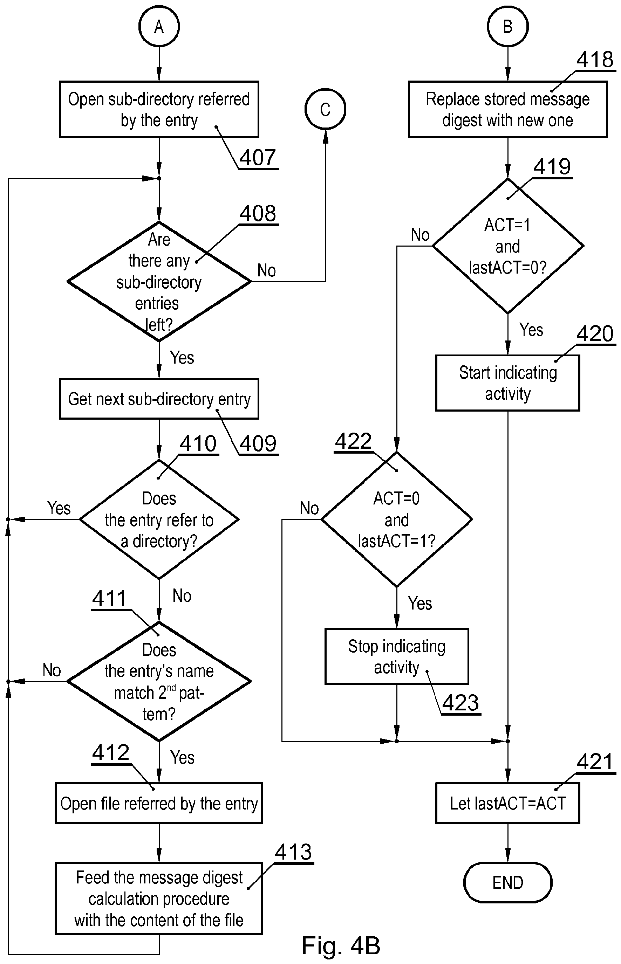

Fig. 2B presents details of controlling the activity indicators in an electronic appliance according to the method of the present invention. The method according to the invention does not rely directly on the interface drivers 230, 240, 250. The method involves launching a new background process, called a LED daemon 270. The LED daemon 270 monitors statistics of all relevant interface drivers 230, 240, 250 via the file system interface 210 and transforms the changes in statistics to the activity state transition messages (as shown in Fig.4A, 4B) and controls the LED driver 113 directly. The interface drivers 230, 240, 250 do not make any specific calls for triggering the activity of the indication LEDs 161-164, they just provide the generic statistics about the transmitted/received data blocks. The Configuration manager 280 transfers a configuration data to the LED daemon 270 by means of IPC (InterProcess Communication) instead of invoking a short-lived LED configuration helper program 220. The LED daemon 270 saves that information in the LED configuration memory block 370 and utilizes it to control the LED driver 113.

Fig. 2C presents a structure of a CPU 111 with modules relevant to the present invention. The Central Processing Unit (CPU) 111 comprises the Configuration manager 280 for transferring the LED indicators configuration data to the LED daemon 270. The LED daemon 270 saves the configuration in the memory and controls the LED driver 113. The LED driver controls the LED indicators 161-164. The CPU further comprises interface drivers, such as the WAN Ethernet driver 230 for controlling the network traffic over the WAN Ethernet port 140, the DSL driver 240 for controlling the network traffic over the DSL line 130 and the Host USB driver 250 for controlling data transfer over the USB port 150.

Fig. 3A presents data transferred by the Configuration manager 380 concerning each LED indicator, which is stored in the memory 114. Data is stored in containers, such as tables, files or other data types.

A LEDs IDs block 310 comprises information concerning identification data of the LED indicator.

A last activity status (lastACT) 350 comprises information concerning previous activity status of the LED indicator.

First level patterns 320 comprise information concerning patterns of matching file system directories (directory names related the group of interface drivers of interest).

Second level patterns 330 comprise information concerning patterns of relevant files (such as enumerated list of files, underneath each directory matching the first pattern, which contribute to the state of activity of an interface). For example, a file related to a networking interface may contain information about the number of received and transmitted packets, and a file related to a USB interface may contain information about number of transmitted URB request blocks.

A last computed hash function values 340 comprise information concerning last known value of the message digest for comparing it against newly computed one. The hash function is used to collapse the content of any number of files under any number of subdirectories into a fixed-size byte buffer (by calculating a message digest of their content).

Statistics 360 comprise statistic information concerning particular interface driver activity.

A LED configuration 370 comprises system-specific information needed by the LED daemon 270 to control the LED driver 113 properly. This, for example, may include a list of numbers of GPIO (General-Purpose Input/Output) lines to turn the LED on and off initially and upon transition from the ACTIVE to INACTIVE state, and a list of GPIO lines to turn the LED on and off during each step of blinking duty cycle.

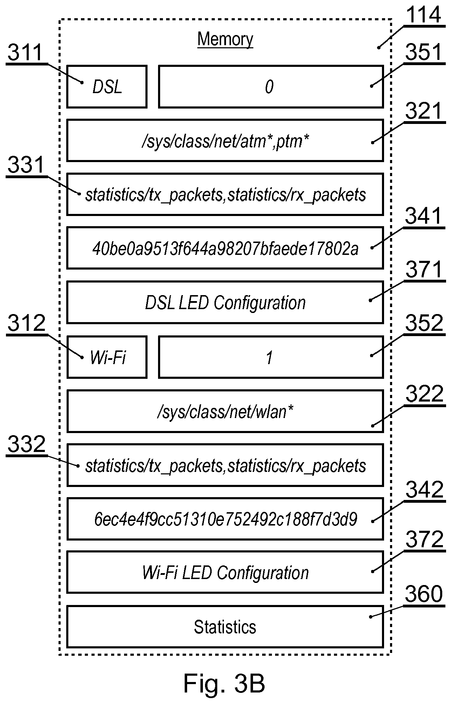

Fig. 3B presents an example of the content of the memory 114. The first set of data concerns the DSL indicator, whose ID is stored in the LEDs ID block 311. The value of the last activity status 351 is equal 0. The first level patterns directory path of the matching file system 321 is "/sys/class/net/atm*,ptm*", while the second level patterns directory of relevant files 331 is "statistics/tx_packets,statistics/rx_packets". The last computed hash function value 341 is equal "40be0a9513f644a98207bfaede17802a". The LED configuration is the DSL LED configuration 371. The statistics information are stored in statistics block 360. The second data set stored in blocks 312, 352, 322, 332, 342, 372, corresponding to the blocks of the first set, concerns Wi-Fi LED indicator.

Figs. 4A-4B present a flowchart of the method for controlling the activity indicators. The method in this example assumes that the interface drivers' statistics are exposed via a file system. Particularly, a specific path in the file system may contain subdirectories named after interfaces (such as network devices or USB devices), and inside those subdirectories may be stored a hierarchy of sub-subdirectories containing files with particular values essential from the point of view of monitoring the activity of the relevant interface.

The procedure shown in Figs. 4A, 4B is operated by the background process 270 periodically, i.e. once the procedure finishes after step 421, it is started again in step 401 after expiry of a pooling period from the beginning of the previous run of the procedure.

The pooling period between consecutive runs of the procedure should be:
- greater than the minimal time needed by an interface to make an action (e.g. transmit or receive a single packet);
- greater than minimal perceivable blinking period of a visual activity indicator; and
- not greater than acceptable delay of indicating activity/lack of activity with a visual indicator.

For example, the pooling period may be set to a value of 500 ms.

First, in step 401, a context of a message digest calculation is initialized (such as calculating an MD5 sum). Next, in step 402, a parent directory extracted from the first pattern is opened. In step 403, it is checked if there are any directory entries left. If so, then in step 404 a next directory entry is retrieved. In step 405 it is checked if the retrieved entry refers to a directory. If not, the method returns to step 403, otherwise it continues to step 406, in which it is checked if the retrieved entry name matches the first pattern. If not, the method returns to step 403, otherwise it continues to step 407, in which the sub-directory referred by the retrieved entry is opened. Next, in step 408, it is checked if there are any sub-directory entries left. If not, the method loops to step 403, otherwise it continues to step 409, in which next sub-directory entry is retrieved. In step 410 it is checked if the retrieved entry refers to a directory. If so, the method loops back to step 408, otherwise it continues to step 411, in which it is checked if the retrieved entry name matches the second pattern. If not, the method loops back to step 408, otherwise it continues to step 412, in which the file referred by the entry is opened. Next, in step 413, the content of the file is transferred to the message digest calculation procedure and the method loops back to step 408.

If in step 403 there are no directories entries left, then in step 414 the message digest calculation procedure is finalized. Next, in step 415, the currently calculated message digest is collected and in step 416 it is compared against the last stored message digest. In step 417, if the newly calculated message digest differs from the stored message digest, then the value of the actual state is changed to 1 (ACT=1), and if both message digests are the same then the value of the actual state is changed to 0 (ACT=0). Next, in step 418, the stored message digest is replaced with the new message digest calculated in step 414. Next, in step 419, it is checked if the actual state value is equal to 1 and if the last state value is equal to 0 (if the ACT=1 and the lastACT=0). If so, then in step 420 the activity indication is started and in step 421 the actual state value is assigned to the last state value variable (lastACT=ACT). If in step 419 the condition is not fulfilled, then in step 422 it is checked if the actual state value is equal to 0 and if the last state value is equal to 1 (if the ACT=0 and the lastACT=1). If not, the method continues directly to step 421, otherwise in step 423 the activity indication is stopped and then the method continues to step 421, after which the method is terminated.

When the activity indication is started in step 420, a state message is sent to the LED driver 113 to activate a particular indicator 161-164 corresponding to the active interface driver 230-250. When the activity indication is stopped in step 423, a state message is sent to the LED driver 113 to de-activate a particular indicator 161-164 corresponding to the inactive interface driver 230-250.

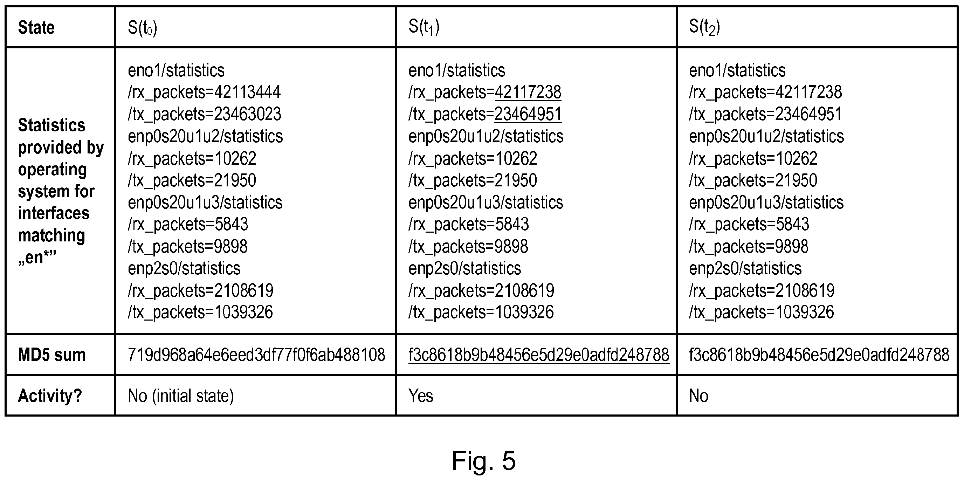

Fig. 5 shows an example of file system directories for network interfaces with system-level names matching "en*", including statistics for time moments t₀, t₁ and t₂. As indicated, statistics for interface "enol" have changed between t₀ and t₁, which can be detected by comparing the MD5 sums.

Activity transition from No to Yes enters a mode in which configured steps of blinking duty cycles are executed periodically.

Activity transition from Yes to No aborts periodic execution of configured duty cycles and re-applies configured initial state of appropriate visual indicator(s), e.g. switches LED(s) on.

At least parts of the methods according to the invention may be computer implemented. Accordingly, the present invention may take the form of an entirely hardware embodiment, an entirely software embodiment (including firmware, resident software, micro-code, etc.) or an embodiment combining software and hardware aspects that may all generally be referred to herein as a "circuit", "module" or "system".

Furthermore, the present invention may take the form of a computer program product embodied in any tangible medium of expression having computer usable program code embodied in the medium.

It can be easily recognized, by one skilled in the art, that the aforementioned method for controlling the activity indicators of electronic appliances may be performed and/or controlled by one or more computer programs. Such computer programs are typically executed by utilizing the computing resources in a computing device. Applications are stored on a non-transitory medium. An example of a non-transitory medium is a non-volatile memory, for example a flash memory while an example of a volatile memory is RAM. The computer instructions are executed by a processor. These memories are exemplary recording media for storing computer programs comprising computer-executable instructions performing all the steps of the computer-implemented method according the technical concept presented herein.

While the invention presented herein has been depicted, described, and has been defined with reference to particular preferred embodiments, such references and examples of implementation in the foregoing specification do not imply any limitation on the invention. It will, however, be evident that various modifications and changes may be made thereto without departing from the broader scope of the technical concept. The presented preferred embodiments are exemplary only, and are not exhaustive of the scope of the technical concept presented herein.

Accordingly, the scope of protection is not limited to the preferred embodiments described in the specification, but is only limited by the claims that follow.

## Claims

1. A method for controlling activity indicators (161-164) for indicating activity of interface drivers (230-250) corresponding to activity of an electronic appliance, wherein the electronic appliance comprises a memory (114) with a file system (210), wherein each interface driver (230-250) has associated a corresponding directory in the file system (210) for storing files representative of an activity of the interface driver (230-250), the method being **characterized in that** it comprises periodically performing a background process (270) comprising:
- calculating (414) a current message digest for the file corresponding to the interface driver (230-250) activity;
- comparing (416) the message digest with the last stored message digest;
- upon detecting a change of the message digest (419, 422), generating (420, 423) a state message for the activity indicator (161-164) corresponding to the interface driver (230-250);
- sending the state message to the activity indicator (161-164).

2. The method according to claim 1, comprising sending the state message to the activity indicator (161-164) via an indicator driver (113).

3. The method according to any of previous claims, wherein the file system (210) comprises first level patterns related to directories corresponding to interface drivers and second level patterns related to files corresponding to interface driver activity.

4. The method according to any of previous claims, wherein calculating (414) the message digest comprises calculating a hash function for collapsing a content of any number of files under any number of sub-directories into a fixed-size byte buffer.

5. A computer program comprising program code means for performing all the steps of the computer-implemented method according to any of claims 1-4 when said program is run on a computer.

6. A computer readable medium storing computer-executable instructions performing all the steps of the computer-implemented method according to any of claims 1-4 when executed on a computer.

7. An electronic appliance comprising:
- activity indicators (161-164) for indicating activity of interface drivers (230-250) of the electronic appliance;
- a memory (114) with a file system (210);
- wherein each interface driver (230-250) has associated a corresponding directory in the file system (210) for storing files representative of an activity of the interface driver (230-250);
**characterized in that** the electronic appliance further comprises a processor (111) configured to periodically operate a background process (270) configured to:
- calculate (414) a current message digest for the file corresponding to the interface driver (230-250) activity;
- compare (416) the message digest with the last stored message digest;
- upon detecting a change of the message digest (419, 422), generate (420, 423) a state message for the activity indicator (161-164) corresponding to the interface driver (230-250);
- send the state message to the activity indicator (161-164).

## Patentansprüche

1. Verfahren zum Steuern von Aktivitätsindikatoren (161-164) zum Angeben der Aktivität von Schnittstellentreibern (230-250) entsprechend der Aktivität eines elektronischen Geräts, wobei das elektronische Gerät einen Speicher (114) mit einem Dateisystem (210) umfasst, wobei mit jedem Schnittstellentreiber (230-250) ein entsprechendes Verzeichnis in dem Dateisystem (210) zum Speichern von Dateien assoziiert ist, die für eine Aktivität des Schnittstellentreibers (230-250) repräsentativ sind, wobei das Verfahren **dadurch gekennzeichnet ist, dass** es ein periodisches Ausführen eines Hintergrundprozesses (270) umfasst, umfassend:
- Berechnen (414) eines aktuellen Message-Digests für die Datei, die der Aktivität des Schnittstellentreibers (230-250) entspricht;
- Vergleichen (416) des Message-Digests mit dem zuletzt gespeicherten Message-Digests;
- bei Erkennen einer Änderung des Message-Digests (419, 422) Erzeugen (420, 423) einer Zustandsnachricht für den Aktivitätsindikator (161-164) entsprechend dem Schnittstellentreiber (230-250);
- Senden der Zustandsnachricht an den Aktivitätsindikator (161-164).

2. Verfahren nach Anspruch 1, umfassend ein Senden der Zustandsnachricht über einen Indikatortreiber (113) an den Aktivitätsindikator (161-164).

3. Verfahren nach einem der vorherigen Ansprüche, wobei das Dateisystem (210) Muster erster Ebene umfasst, die sich auf Verzeichnisse beziehen, die Schnittstellentreibern entsprechen, und Muster zweiter Ebene, die sich auf Dateien beziehen, die einer Schnittstellentreiberaktivität entsprechen.

4. Verfahren nach einem der vorherigen Ansprüche, wobei ein Berechnen (414) des Message-Digests ein Berechnen einer Hash-Funktion zum Zusammenfassen des Inhalts einer beliebigen Anzahl von Dateien unter einer Anzahl von Unterverzeichnissen in einen Byte-Puffer fester Größe umfasst.

5. Computerprogramm mit Programmcode-Mitteln zum Ausführen aller Schritte des computerimplementierten Verfahrens nach einem der Ansprüche 1-4, wenn das Programm auf einem Computer ausgeführt wird.

6. Computerlesbares Medium, das computerausführbare Anweisungen speichert, die alle Schritte des computerimplementierten Verfahrens nach einem der Ansprüche 1-4 ausführen, wenn sie auf einem Computer ausgeführt werden.

7. Elektronisches Gerät, umfassend:
- Aktivitätsindikatoren (161-164) zum Angeben von Aktivität von Schnittstellentreibern (230-250) des elektronischen Geräts;
- einen Speicher (114) mit einem Dateisystem (210);
- wobei mit jedem Schnittstellentreiber (230-250) ein entsprechendes Verzeichnis in dem Dateisystem (210) zum Speichern von Dateien assoziiert ist, die für eine Aktivität des Schnittstellentreibers (230-250) repräsentativ sind;
**dadurch gekennzeichnet, dass** das elektronische Gerät ferner einen Prozessor (111) umfasst, der konfiguriert ist, um periodisch einen Hintergrundprozess (270) zu betreiben, der zu Folgendem konfiguriert ist:
- Berechnen (414) eines aktuellen Message-Digests für die Datei, die der Aktivität des Schnittstellentreibers (230-250) entspricht;
- Vergleichen (416) des Message-Digests mit dem zuletzt gespeicherten Message-Digests;
- bei Erkennen einer Änderung des Message-Digests (419, 422) Erzeugen (420, 423) einer Zustandsnachricht für den Aktivitätsindikator (161-164) entsprechend dem Schnittstellentreiber (230-250);
- Senden der Zustandsnachricht an den Aktivitätsindikator (161-164).

## Revendications

1. Procédé permettant de commander des indicateurs d'activité (161-164) destinés à indiquer l'activité de pilotes d'interface (230-250) correspondant à l'activité d'un appareil électronique, ledit appareil électronique comprenant une mémoire (114) avec un système de fichiers (210), chaque pilote d'interface (230-250) se voyant associé un répertoire correspondant dans le système de fichiers (210) en vue du stockage des fichiers représentatifs d'une activité du pilote d'interface (230-250), le procédé étant **caractérisé en ce qu'**il comprend la réalisation périodique d'un processus d'arrière-plan (270) comprenant :
- le calcul (414) d'un condensé de message actuel pour le fichier correspondant à l'activité du pilote d'interface (230-250) ;
- la comparaison (416) du condensé de message avec le dernier condensé de message stocké ;
- lors de la détection d'un changement du condensé de message (419, 422), la génération (420, 423) d'un message d'état pour l'indicateur d'activité (161-164) correspondant au pilote d'interface (230-250) ;
- l'envoi du message d'état à l'indicateur d'activité (161-164).

2. Procédé selon la revendication 1, comprenant l'envoi du message d'état à l'indicateur d'activité (161-164) par l'intermédiaire d'un pilote d'indicateur (113).

3. Procédé selon l'une quelconque des revendications précédentes, ledit système de fichiers (210) comprenant des modèles de premier niveau liés aux répertoires correspondant aux pilotes d'interface et des modèles de second niveau liés aux fichiers correspondant à l'activité de pilote d'interface.

4. Procédé selon l'une quelconque des revendications précédentes, ledit calcul (414) du condensé de message comprenant le calcul d'une fonction de hachage pour regrouper le contenu d'un nombre quelconque de fichiers sous un nombre quelconque de sous-répertoires dans une mémoire tampon d'octets de taille fixe.

5. Programme informatique comprenant un moyen de code de programme destiné à réaliser toutes les étapes du procédé mis en œuvre par ordinateur selon l'une quelconque des revendications 1 à 4 lorsque ledit programme est exécuté sur un ordinateur.

6. Support lisible par ordinateur stockant des instructions exécutables par ordinateur réalisant toutes les étapes du procédé mis en œuvre par ordinateur selon l'une quelconque des revendications 1 à 4 lorsqu'elles sont exécutées sur un ordinateur.

7. Appareil électronique comprenant :
- des indicateurs d'activité (161-164) destinés à indiquer l'activité des pilotes d'interface (230-250) de l'appareil électronique ;
- une mémoire (114) avec un système de fichiers (210) ;
- chaque pilote d'interface (230-250) se voyant associé un répertoire correspondant dans le système de fichiers (210) en vue du stockage des fichiers représentatifs d'une activité du pilote d'interface (230-250) ;
**caractérisé en ce que** l'appareil électronique comprend en outre un processeur (111) configuré pour exploiter périodiquement un processus d'arrière-plan (270) configuré pour :
- calculer (414) un condensé de message actuel pour le fichier correspondant à l'activité du pilote d'interface (230-250) ;
- comparer (416) le condensé de message avec le dernier condensé de message stocké ;
- lors de la détection d'un changement du condensé de message (419, 422), générer (420, 423) un message d'état pour l'indicateur d'activité (161-164) correspondant au pilote d'interface (230-250) ;
- envoyer le message d'état à l'indicateur d'activité (161-164).
